(19) Europäisches Patentamt
European Patent Office
Office européen des brevets

(11) **EP 2 873 306 B1**

(12) **FASCICULE DE BREVET EUROPEEN**

(45) Date de publication et mention
de la délivrance du brevet:
**08.05.2019 Bulletin 2019/19**

(51) Int Cl.:
***H05H 1/46*** *(2006.01)*

(21) Numéro de dépôt: **13735269.6**

(22) Date de dépôt: **10.07.2013**

(86) Numéro de dépôt international:
**PCT/EP2013/064574**

(87) Numéro de publication internationale:
**WO 2014/009410 (16.01.2014 Gazette 2014/03)**

(54) **APPLICATEUR MICRO-ONDE COAXIAL POUR LA PRODUCTION DE PLASMA**

KOAXIALER MIKROWELLENAPPLIKATOR ZUR PLASMAERZEUGUNG

COAXIAL MICROWAVE APPLICATOR FOR PLASMA PRODUCTION

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **11.07.2012 FR 1256677**

(43) Date de publication de la demande:
**20.05.2015 Bulletin 2015/21**

(73) Titulaire: **Université Grenoble Alpes
38400 Saint-Martin-d'Hères (FR)**

(72) Inventeurs:
• **LACOSTE, Ana
F-38950 Saint Martin le Vinoux (FR)**
• **PELLETIER, Jacques
F-38400 Saint Martin d'Hères (FR)**

(74) Mandataire: **Hautier IP
20, rue de la Liberté
06000 Nice (FR)**

(56) Documents cités:
WO-A1-03/103003      WO-A1-2008/009558
WO-A1-2010/049456    WO-A2-2008/009559

## Description

## DOMAINE DE L'INVENTION

La présente invention concerne un applicateur micro-onde coaxial pour la production de plasma ainsi qu'un procédé de production de plasma dans un domaine de pression pouvant aller de $10^{-2}$ Pa à $10^3$ Pa (c'est-à-dire de l'ordre de $10^{-4}$ torr à la dizaine de torr).

## ARRIERE PLAN DE L'INVENTION

La production de plasmas à partir de champ électromagnétique micro-onde peut s'effectuer selon des mécanismes différents suivant le domaine de pression considéré et la présence ou non d'un champ magnétique statique (par opposition à la composante magnétique du champ électromagnétique micro-onde).

Au-dessous du torr (1 torr = 133 Pa), en présence d'un champ magnétique d'intensité suffisante, la production de plasma par micro-ondes peut être obtenue par un mode de couplage résonnant, appelé résonance cyclotronique électronique (RCE).

A la résonance cyclotronique électronique, les électrons sont accélérés très efficacement par le champ électrique micro-onde si l'intensité du champ magnétique (qui peut être produit par des bobines ou des aimants permanents) est telle que la fréquence de giration des électrons dans le champ magnétique est égale à la fréquence $f_0$ du champ électrique micro-onde, soit :

$$f_0 = e\, B_0\, /\, 2\, \pi\, m_e \qquad (1)$$

où $m_e$ est la masse de l'électron, $-e$ est la charge de l'électron et $B_0$ l'intensité du champ magnétique correspondant à la résonance cyclotronique électronique (RCE) pour la fréquence micro-onde $f_0$.

En l'absence de collisions, la trajectoire des électrons dits rapides, ainsi accélérés à la résonance cyclotronique électronique dans le champ magnétique, s'enroule alors suivant un mouvement hélicoïdal autour d'une ligne de champ magnétique et chaque électron peut ainsi osciller entre deux points miroir où la vitesse de l'électron parallèle à la ligne de champ magnétique s'annule et change de signe.

En effet, lorsque l'intensité du champ magnétique augmente, en raison de la conservation du moment magnétique de l'électron sur sa trajectoire (invariant adiabatique du mouvement), la vitesse de l'électron parallèle à la ligne de champ diminue au profit de la vitesse de rotation autour de la ligne de champ magnétique (conservation de l'énergie cinétique de l'électron) jusqu'à s'annuler au premier point miroir, puis changer de sens en se dirigeant vers le second point miroir M, et ainsi de suite.

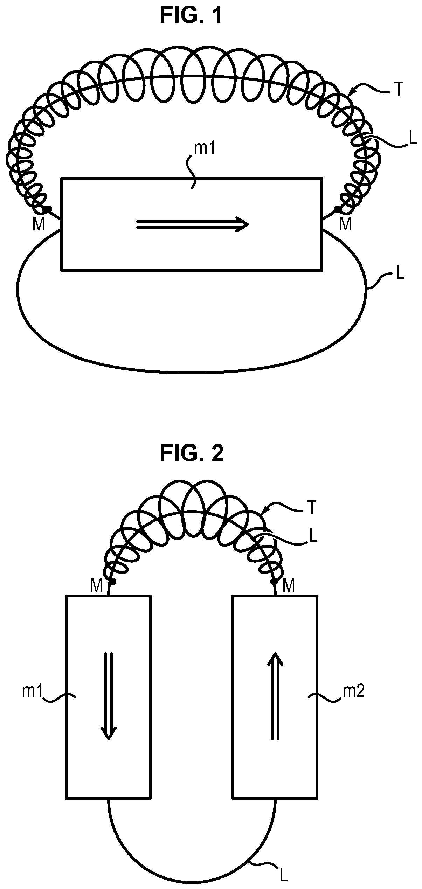

Ces points miroir M, où l'intensité du champ magnétique est identique, sont généralement situés face à deux pôles magnétiques opposés d'un même aimant (comme à la figure 1) ou de deux aimants adjacents (cf. figure 2).

La figure 1 illustre un aimant permanent m1 dont le sens d'aimantation est schématisé par la flèche.

Deux lignes de champ L sont représentées et la trajectoire T d'un électron, qui est entraîné en rotation autour d'une ligne de champ L, est schématisée sur l'une d'elles.

La figure 2 illustre deux aimants permanents m1 et m2 disposés parallèlement l'un à l'autre et dont les sens d'aimantation, schématisés par les flèches, sont opposés.

Dans ce cas, les lignes de champ L relient les pôles adjacents des deux aimants, la trajectoire d'un électron étant schématisée sur l'une d'elles.

Le mouvement décrit ci-dessus se poursuit jusqu'à ce que l'électron rapide accéléré à la résonance cyclotronique électronique effectue des collisions, et en particulier des collisions ionisantes.

Le plasma, c'est-à-dire les électrons et les ions ainsi produits le long des trajectoires des électrons rapides accélérés à la résonance cyclotronique électronique, diffuse alors, par collisions successives, de part et d'autre de ces trajectoires, donc perpendiculairement aux lignes de champ.

Plusieurs dispositifs utilisant la résonance cyclotronique électronique sont décrits dans les documents FR 2 797 372, FR 2 838 020, FR 2 904 177, FR 2 904 178 et FR 2 938 150.

D'une manière générale, ces dispositifs comprennent des structures magnétiques à aimants permanents disposées en sortie d'un applicateur micro-onde coaxial (applicateur micro-onde).

Ces structures magnétiques sont telles que tous les électrons rapides accélérés à la résonance cyclotronique électronique oscillent entre deux points miroirs M sans rencontrer de surfaces matérielles pouvant les collecter.

Ainsi, la puissance micro-onde absorbée par les électrons pour leur accélération est consacrée entièrement à la production du plasma par collisions ionisantes, et non au bombardement des surfaces coupant leur trajectoire, d'où un rendement optimisé au niveau de la production du plasma par les électrons rapides.

Tous ces dispositifs ont permis de produire des plasmas micro-onde avec d'excellentes performances.

A plus haute pression, au-delà du dixième de torr (13,3 Pa) ou du torr (133 Pa), c'est-à-dire lorsque la fréquence de collisions ν des électrons dans le plasma devient de l'ordre de grandeur de la pulsation micro-onde ω (ν ≈ ω), la résonance cyclotronique électronique devient moins efficace et le chauffage des électrons, c'est-à-dire leur accélération progressive dans le champ électrique micro-onde s'effectue par exemple par absorption collisionnelle immédiatement en sortie d'applicateur.

Dans ce mode de fonctionnement à plus haute pression, au-dessus de quelques Pa, il faut alors éviter la production de plasma au sein de l'applicateur coaxial en séparant le volume sous pression réduite au-delà du plan de sortie de l'applicateur de la pression atmosphérique par une fenêtre diélectrique étanche en sortie immédiate d'applicateur.

On pourra à cet égard se référer au document FR 2 840 451.

Malgré les améliorations apportées aux applicateurs micro-onde par les documents cités plus haut, tous ces applicateurs présentent deux inconvénients majeurs, à savoir :

- d'une part, les électrons rapides accélérés à la résonance cyclotronique électronique restent piégés près des parois par le champ magnétique entre deux points miroir situés près des pôles : la production du plasma reste donc localisée en sortie d'applicateur, c'est-à-dire près des parois ;
- d'autre part, le plasma produit par les électrons rapides diffuse de part et d'autre des trajectoires des électrons rapides, c'est-à-dire perpendiculairement aux lignes de champ magnétique. Comme la probabilité de diffuser d'un côté ou de l'autre de la trajectoire des électrons rapides est la même, la probabilité pour le plasma de diffuser vers les parois et celle de diffuser en s'éloignant des parois sont statistiquement égales. On peut alors considérer que la moitié du plasma produit par les électrons rapides va se perdre directement sur les parois sans remplir le volume utile de plasma situé au-delà de la trajectoire en s'éloignant des parois.

Un but de l'invention est donc de concevoir un applicateur micro-onde coaxial permettant de remédier à ces deux inconvénients.

**BREVE DESCRIPTION DE L'INVENTION**

Il est proposé un applicateur micro-onde coaxial pour la production de plasma, comprenant un tube coaxial électriquement conducteur formé d'une âme centrale et d'un conducteur externe entourant l'âme centrale et séparé de celle-ci par un volume annulaire de propagation des micro-ondes.

Conformément à l'invention, ledit applicateur comprend :

- un aimant permanent cylindrique dont la direction d'aimantation est parallèle à l'axe de l'applicateur, agencé à l'extrémité de l'âme centrale et,
- au moins un aimant permanent annulaire dont la direction d'aimantation est parallèle à l'axe de l'applicateur et de même sens que l'aimantation de l'aimant cylindrique central, agencé à l'extrémité du conducteur externe,

tous les aimants agencés à l'extrémité du tube coaxial présentant le même sens d'aimantation, l'aimantation desdits aimants étant choisie de sorte à former un champ magnétique propre à procurer, dans une zone distante de l'extrémité de l'applicateur, un couplage de résonance cyclotronique électronique avec le champ électrique micro-onde généré par ledit applicateur, le rayon extérieur et l'aimantation de l'aimant annulaire étant en outre choisis de sorte que les lignes de champ magnétique générées par lesdits aimants traversent la zone de couplage de résonance cyclotronique électronique selon une direction sensiblement parallèle à l'axe de l'applicateur.

Ce nouvel applicateur, qui laisse libre l'espace en sortie, permet en outre de produire le plasma, non seulement à basse pression par résonance cyclotronique électronique, mais aussi à plus haute pression (où le champ magnétique devient beaucoup moins efficace), dans des conditions de couplage par exemple de type absorption collisionnelle.

Par résonance cyclotronique électronique, on entend la situation dans laquelle l'intensité $B_0$ du champ magnétique produit par les aimants permanents agencés à l'extrémité de l'applicateur est telle que la fréquence de giration des électrons de masse $m_e$ et de charge -e dans ledit champ magnétique est égale à la fréquence $f_0$ du champ électrique micro-onde, soit :

$$f_0 = e\, B_0\, /\, 2\,\pi\, m_e \quad (1)$$

Selon un mode de réalisation, le rayon extérieur de l'aimant annulaire est au moins le double du rayon extérieur du volume annulaire de propagation des micro-ondes.

Selon un mode de réalisation, l'applicateur comprend, autour de l'aimant annulaire, dit premier aimant annulaire, un second aimant permanent annulaire, à aimantation axiale de même sens que l'aimantation de l'aimant cylindrique central, ledit second aimant annulaire présentant une intensité de champ magnétique supérieure à celle du premier aimant annulaire.

Lesdits premier et second aimants annulaires peuvent aussi être constitués du même matériau magnétique, la longueur dans la direction axiale du second aimant annulaire étant supérieure à celle du premier aimant annulaire.

De manière alternative, lesdits premier et second aimants annulaires présentent la même longueur dans la direction axiale et le matériau du second aimant annulaire présente une aimantation supérieure à celle du premier aimant annulaire.

Selon un mode de réalisation, l'applicateur comprend un épaulement recouvrant une région externe de l'extrémité de l'aimant annulaire, de sorte à limiter radialement la surface de la zone de couplage de résonance cyclotronique électronique.

L'âme centrale et/ou le conducteur externe du tube coaxial peuvent en outre comprendre un circuit de circulation d'un fluide de refroidissement.

Selon un mode de réalisation, le volume annulaire de propagation des micro-ondes est obturé à l'extrémité de l'applicateur par une fenêtre en un matériau diélectrique.

Selon un autre mode de réalisation, le volume annulaire de propagation des micro-ondes est obturé, en amont de l'extrémité de l'applicateur, par une fenêtre en un matériau diélectrique.

De manière avantageuse, ledit volume annulaire de propagation des micro-ondes peut être adapté pour la circulation d'un fluide diélectrique de refroidissement.

Un autre objet concerne un dispositif de production de plasma comprenant une enceinte contenant un gaz plasmagène et au moins un applicateur tel que décrit ci-dessus, dont l'extrémité portant les aimants permanents cylindrique et annulaire débouche dans ladite enceinte.

Selon un mode de réalisation, ledit dispositif comprend une pluralité d'applicateurs répartis dans l'enceinte de sorte à former un réseau unidimensionnel, bidimensionnel ou tridimensionnel.

Selon une forme d'exécution, les aimants permanents de l'ensemble desdits applicateurs présentent le même sens d'aimantation.

Dans ce cas, le réseau d'applicateurs est avantageusement entouré par une structure magnétique présentant une direction d'aimantation parallèle à celui des applicateurs mais de sens opposé.

De manière alternative, le réseau d'applicateurs est entouré par une structure magnétron de pulvérisation.

Selon une autre forme d'exécution, les aimants permanents de l'ensemble desdits applicateurs présentent des aimantations alternées d'un applicateur à l'autre.

De préférence, la pression absolue dans l'enceinte est comprise entre $10^{-2}$ Pa et $10^3$ Pa.

Un autre objet concerne un procédé de production de plasma par micro-ondes dans une enceinte contenant un gaz plasmagène, comprenant la propagation de micro-ondes dans un applicateur micro-onde coaxial tel que décrit précédemment débouchant dans ladite enceinte et l'application, à l'extrémité dudit applicateur, d'un champ magnétique propre à procurer un couplage cyclotronique électronique avec le champ électrique micro-onde dans une zone distante de l'extrémité de l'applicateur, les lignes dudit champ magnétique traversant la zone de couplage de résonance cyclotronique électronique selon une direction sensiblement parallèle à l'axe de l'applicateur.

De préférence, la pression absolue dans l'enceinte est comprise entre $10^{-2}$ Pa et $10^3$ Pa.

Selon un mode de réalisation, la pression absolue dans l'enceinte est inférieure à 133 Pa, de préférence inférieure à 1 Pa, de manière préférée inférieure à 0,1 Pa.

Selon une forme d'exécution de l'invention, on produit le plasma au moyen d'une pluralité d'applicateurs répartis dans l'enceinte de sorte à former un réseau unidimensionnel, bidimensionnel ou tridimensionnel.

De manière avantageuse, on refroidit l'applicateur en faisant circuler un fluide de refroidissement dans l'âme centrale de l'applicateur ou dans le volume de propagation des micro-ondes.

De manière préférée, on obture le volume annulaire de propagation des micro-ondes par une fenêtre diélectrique étanche à l'extrémité ou en amont de l'extrémité de l'applicateur.

**BREVE DESCRIPTION DES DESSINS**

D'autres caractéristiques et avantages de l'invention ressortiront de la description détaillée qui va suivre, en référence aux dessins annexés sur lesquels :

- la figure 1 est un schéma de principe illustrant une trajectoire électronique en présence d'un unique aimant permanent,
- la figure 2 est un schéma de principe illustrant une trajectoire électronique en présence de deux aimants permanents adjacents d'aimantations opposées,

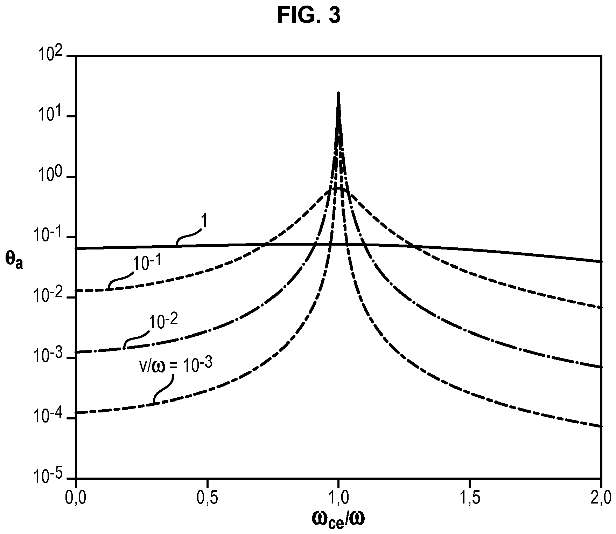

- la figure 3 est un graphique présentant l'évolution, à champ électrique constant, de la puissance $\theta_a$ absorbée par électron à différentes fréquences, pour différentes valeurs du rapport entre la fréquence de collision $v$ et la pulsation micro-onde $\omega$,

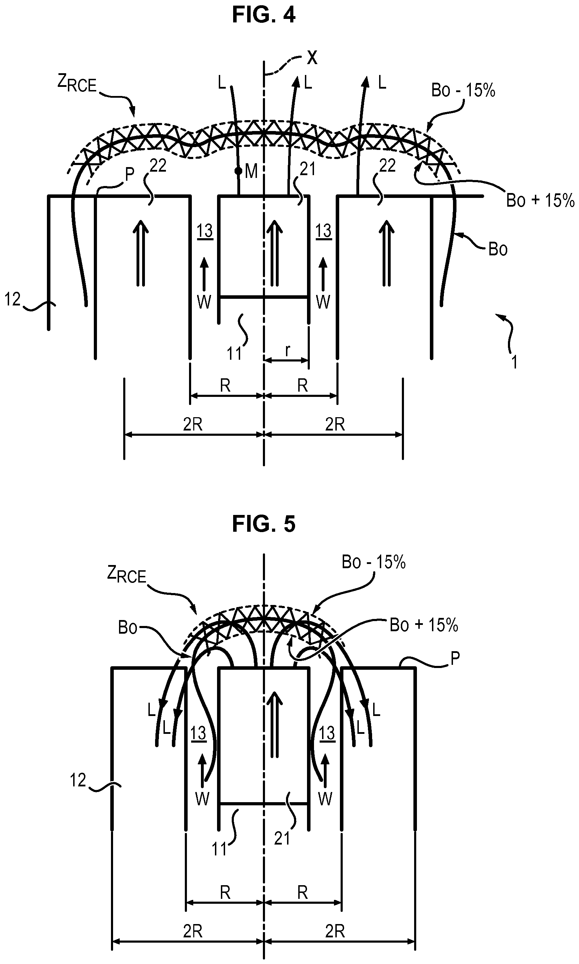

- la figure 4 est un schéma en coupe d'un applicateur micro-onde selon un premier mode de réalisation de l'invention,
- la figure 5 est un schéma en coupe d'un applicateur non conforme à l'invention,

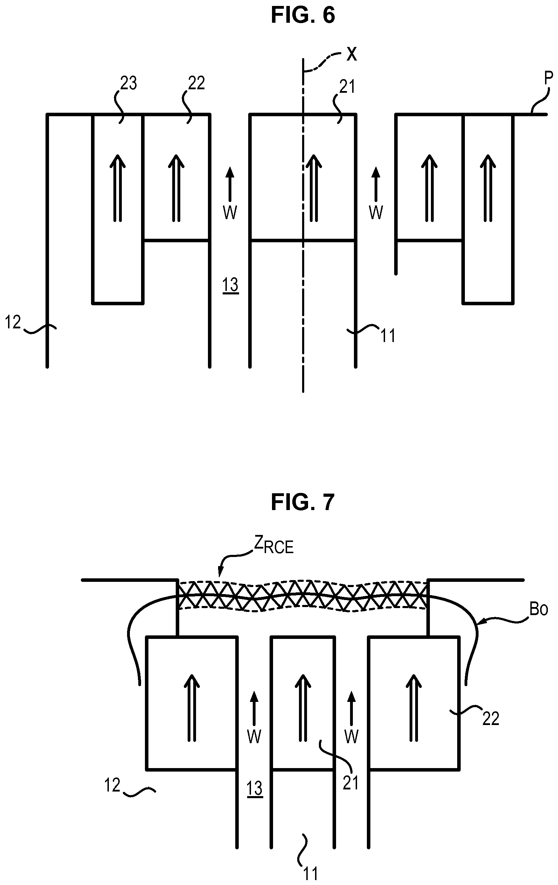

- la figure 6 est un schéma en coupe d'un applicateur micro-onde selon un deuxième mode de réalisation de l'invention,
- la figure 7 est un schéma en coupe d'un applicateur micro-onde selon un troisième mode de réalisation de l'invention,

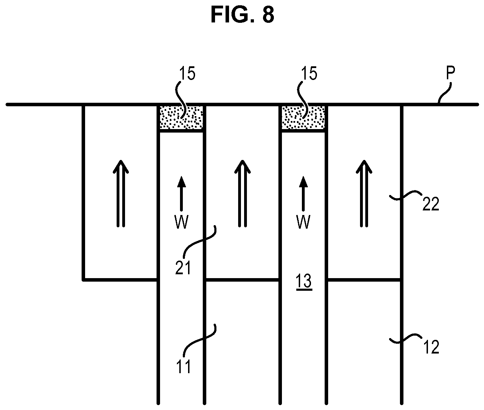

- la figure 8 est un schéma en coupe d'un applicateur micro-onde selon un mode de réalisation de l'invention incorporant la circulation d'un fluide de refroidissement,

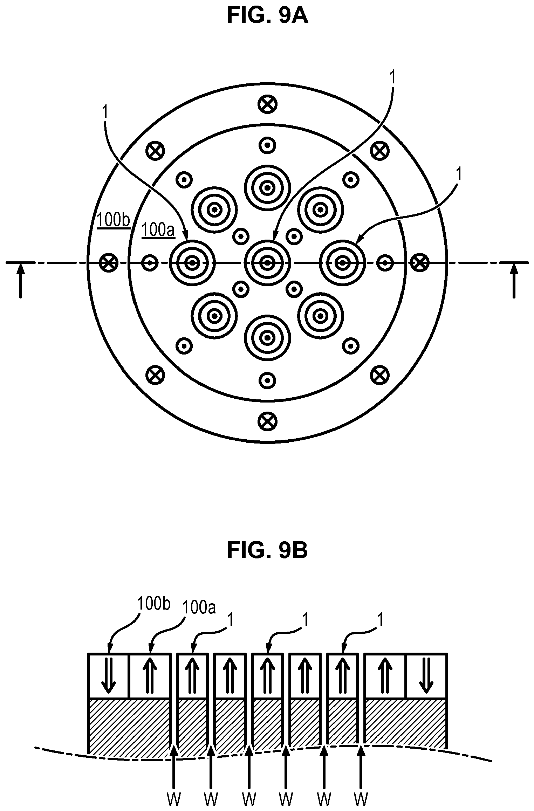

- la figure 9A est une vue de dessus d'un réseau d'applicateurs présentant tous le même sens d'aimantation et d'une structure magnétique permettant de refermer le champ magnétique à la périphérie du réseau ; la figure 9B est une vue en coupe dudit réseau et de ladite structure magnétique,

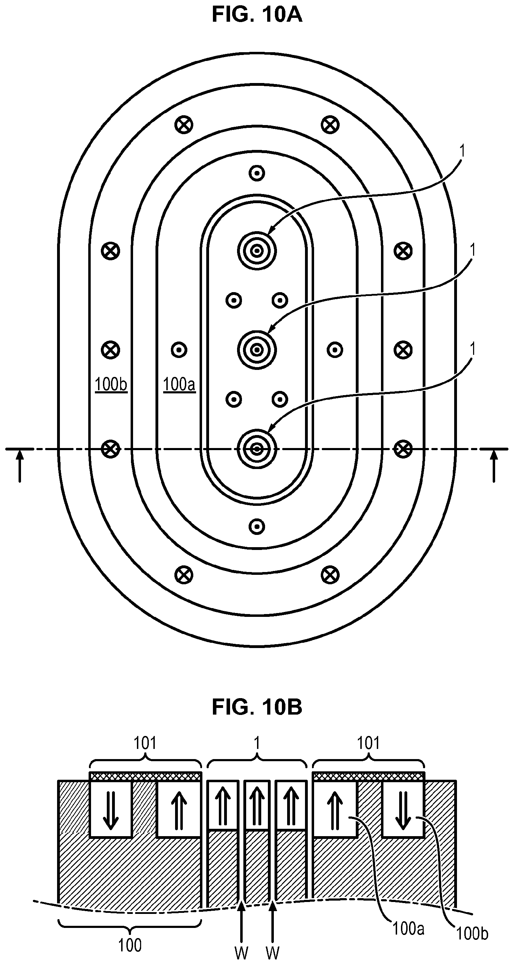

- la figure 10A est une vue de dessus d'un réseau d'applicateurs présentant tous le même sens d'aimantation, entouré d'une structure magnétron de pulvérisation ; la figure 10B est une vue en coupe dudit réseau et de ladite structure magnétron.

## DESCRIPTION DETAILLEE DE L'INVENTION

L'invention propose un applicateur micro-onde coaxial comprenant, à son extrémité, une structure magnétique qui laisse libre l'espace à la sortie de l'applicateur et qui permet la production de plasma non seulement à basse pression, par résonance cyclotronique électronique, mais aussi à plus haute pression, lorsque le champ magnétique devient moins efficace, par couplage par exemple de type absorption collisionnelle.

D'une manière générale, ladite structure magnétique est conçue de sorte que les lignes de champ magnétique générées par cette structure traversent la zone de couplage de résonance cyclotronique électronique selon une direction sensiblement parallèle à l'axe de l'applicateur.

Cette zone de couplage peut être définie par l'intersection de deux zones :

- d'une part, la zone de champ magnétique située près de la surface de champ magnétique d'intensité égale à $B_0$ ($B_0$ étant l'intensité du champ magnétique remplissant la condition de résonance RCE pour la fréquence $f_0$ du champ électrique micro-onde).

On considère typiquement une zone dans laquelle l'intensité du champ magnétique est comprise entre $B_0$ - 15% et $B_0$ + 15% (voire entre $B_0$- 10% et $B_0$ + 10%), en raison de l'élargissement de la résonance due aux collisions.

A titre d'exemple, à 2,45 GHz, où $B_0$ = 875 gauss (1 gauss = $10^{-4}$ tesla), cette zone s'étend approximativement de 750 à 1000 gauss.

La figure 3, qui est issue de l'ouvrage de M. Moisan et J. Pelletier, Physique des plasmas collisionnels - Application aux décharges haute fréquence, EDP Sciences, Collection Grenoble Sciences, Les Ulis, France (2006), page 215, illustre l'évolution, pour un champ électrique constant, de la puissance $\theta_a$ absorbée par électron depuis $\omega_{ce}$ = 0, jusqu'à la condition de résonance $\omega_{ce}$ = $\omega$, et ensuite au-delà, pour différentes valeurs du rapport v/$\omega$ (ce rapport pouvant être considéré comme proportionnel à la pression).

Cette courbe montre que la résonance est fortement amortie (se traduisant par l'élargissement du pic) lorsque la fréquence de collisions augmente ou lorsque l'on s'écarte de la résonance.

- d'autre part, la zone d'application des micro-ondes en sortie de l'applicateur coaxial.

Cette zone d'application des micro-ondes englobe la zone de fort champ électrique micro-onde située entre l'âme centrale et le conducteur externe de l'applicateur coaxial.

Cette zone s'étend en pratique sur un rayon de l'ordre de deux fois le rayon de l'applicateur (lequel correspond au rayon intérieur du conducteur externe).

La figure 4 illustre un mode de réalisation d'un applicateur conforme à l'invention, et dont la structure magnétique permet de remplir la condition définie ci-dessus.

De manière connue en elle-même, ledit applicateur est un applicateur micro-onde coaxial qui comprend un tube coaxial électriquement conducteur.

Ledit tube coaxial est formé d'une âme centrale 11 et d'un conducteur externe 12 (généralement concentrique) entourant l'âme centrale 11 et séparé de celle-ci par un volume annulaire 13 de propagation des micro-ondes.

Le tube coaxial 11, 12 présente une symétrie de révolution autour d'un axe X, également désigné comme axe de l'applicateur.

Les extrémités de l'âme centrale 11 et du conducteur externe annulaire 12 sont ici coplanaires et constituent un plan dit plan de sortie de l'applicateur

De manière conventionnelle, l'applicateur est alimenté en micro-ondes par un générateur de micro-ondes (non illustré) qui peut être une source magnétron ou une source à état solide (transistors).

Les fréquences micro-onde employées peuvent aller de la centaine de MHz jusqu'à la dizaine de GHz, domaine incluant les fréquences ISM (industrielles, scientifiques et médicales) de 433 MHz, 2,45 GHz et 5,80 GHz.

Selon les applications, la puissance micro-onde appliquée peut aller de un ou quelques watts (par exemple pour l'éclairage) à quelques centaines de watts ou davantage (par exemple pour le traitement des effluents gazeux).

Des composants tels qu'un circulateur (isolateur), un dispositif d'adaptation d'impédance, un dispositif de mesure des puissances incidente et réfléchie, etc. peuvent être intercalés entre le générateur et l'applicateur.

La conception et l'agencement de ces différents composants sont à la portée de l'homme du métier.

Conformément à l'invention, ledit applicateur comprend en outre un aimant permanent cylindrique 21, agencé à l'extrémité de l'âme centrale 11 et dont la direction d'aimantation (schématisée par une flèche) est parallèle à l'axe X.

Ledit aimant présente de préférence un rayon sensiblement identique à celui de l'âme centrale 11.

Concrètement, le rayon de l'aimant cylindrique peut être légèrement inférieur à celui de l'âme centrale et l'âme centrale peut comprendre un logement cylindrique (non illustré ici) à son extrémité pour loger l'aimant cylindrique.

Par ailleurs, l'applicateur comprend également un aimant annulaire 22, agencé à l'extrémité du conducteur externe 12 du tube coaxial et dont la direction d'aimantation (schématisée par une flèche) est parallèle à l'axe X et de même sens que celle de l'aimant cylindrique 21.

De préférence, ledit aimant annulaire présente un rayon intérieur égal à celui du conducteur externe 12, qui correspond au rayon extérieur du volume annulaire 13 de propagation des micro-ondes, noté R.

Concrètement, le rayon intérieur de l'aimant annulaire peut être légèrement supérieur à celui du conducteur externe, tandis que le rayon extérieur de l'aimant annulaire est inférieur à celui du conducteur externe, et le conducteur externe peut comprendre un logement annulaire (non illustré ici) à son extrémité pour loger l'aimant annulaire.

Les aimants peuvent être rendus solidaires du tube coaxial par tout moyen approprié.

Dans l'applicateur conforme à l'invention, tous les aimants agencés à l'extrémité du tube coaxial présentent le même sens d'aimantation, de sorte que les lignes de champ produites par lesdits aimants dans la partie centrale d'application des micro-ondes (c'est-à-dire dans la région située entre l'aimant cylindrique 21 et l'aimant annulaire 22) ont une direction sensiblement axiale.

L'aimantation de l'aimant cylindrique 21 et de l'aimant annulaire 22 est choisie de sorte à former un champ magnétique propre à procurer, dans une zone $Z_{RCE}$ distante de l'extrémité de l'applicateur, un couplage de résonance cyclotronique électronique avec le champ électrique micro-onde généré par l'applicateur.

Ceci suppose que l'aimantation desdits aimants 21 et 22 soit suffisante pour générer, à distance du plan de sortie P de l'applicateur, un champ magnétique présentant l'intensité $B_0$ permettant la résonance cyclotronique électronique en fonction de la fréquence micro-onde prévue, selon la formule (1) présentée en introduction.

En particulier, comme déjà indiqué plus haut, les aimantations des aimants 21 et 22 sont de même sens selon l'axe X.

L'homme du métier est à même de sélectionner, parmi les aimants permanents disponibles commercialement, ceux qui présentent une aimantation adéquate.

A titre purement indicatif, pour une excitation du plasma à la résonance cyclotronique électronique par des micro-ondes à 2,45 GHz, la condition de résonance ($B_0 = 875$ gauss) requiert des aimants capables de fournir dans le plan de sortie de l'applicateur un champ magnétique dont l'intensité peut dépasser 1000 gauss, par exemple 1500 à 2000 gauss, valeur qui peut être facilement fournie par des aimants permanents conventionnels en samarium-cobalt.

La distance entre le plan de sortie P de l'applicateur et la région dans laquelle on obtient le champ magnétique d'intensité $B_0$ doit être suffisante pour que la zone $Z_{RCE}$, qui correspond à une zone où le champ magnétique est compris entre $B_0$+15% et $B_0$-15%, présente une bonne uniformité du champ magnétique.

En effet, le volume annulaire 13 de propagation de micro-ondes, situé entre les aimants 21 et 22, provoque une perturbation locale du champ magnétique, celui-ci décroissant sensiblement au niveau de ce volume annulaire.

Cette perturbation tend à diminuer au fur et à mesure que l'on s'éloigne du plan de sortie de l'applicateur, de sorte que, à partir d'une certaine distance, les zones d'iso-intensité du champ magnétique sont sensiblement parallèles au plan de sortie P de l'applicateur.

L'homme du métier est en mesure de simuler la variation dans l'espace de l'intensité du champ magnétique généré par les aimants 21 et 22 et d'en déduire l'aimantation requise pour que la région dans laquelle le champ magnétique est égal à $B_0$+15% soit distante du plan P de sortie de l'applicateur et sensiblement parallèle à celui-ci.

Il est par ailleurs possible de minimiser l'effet perturbateur du volume annulaire 13 en minimisant la largeur de celui-ci.

Ainsi, de manière préférée, la largeur du volume annulaire 13 (c'est-à-dire la différence R-r entre le rayon intérieur R du conducteur externe 12 et le rayon r de l'âme centrale 11) est inférieure au rayon r de l'âme centrale 11, par exemple de l'ordre de la moitié ou moins de la moitié du rayon r.

Une autre manière de minimiser l'effet perturbateur du volume annulaire 13 est d'augmenter la longueur des aimants 21 et 22 (selon l'axe X).

D'une manière générale, il est souhaitable, pour minimiser l'effet perturbateur du volume annulaire 13, que la longueur des aimants 21 et 22 (selon l'axe X) soit, d'une part, grande devant la différence R-r, et, d'autre part, grande devant le rayon r de l'âme centrale, par exemple d'une longueur de l'ordre du diamètre 2r de l'âme centrale.

D'autre part, une autre caractéristique de l'applicateur selon l'invention est l'obtention de lignes de champ magnétique générées par l'aimant cylindrique 21 et l'aimant annulaire 22 qui traversent la zone de couplage de résonance cyclotronique électronique $Z_{RCE}$ selon une direction sensiblement parallèle à l'axe X de l'applicateur.

Cet effet peut être obtenu par un choix judicieux du rayon extérieur et de l'aimantation de l'aimant annulaire 22.

En effet, plus l'aimant annulaire 22 présente un rayon extérieur important, plus les lignes d'iso-intensité du champ magnétique généré à distance de l'applicateur restent parallèles au plan de sortie P de l'applicateur sur un rayon important.

Par conséquent, la zone $Z_{RCE}$ étant délimitée, dans la direction radiale, par la zone dans laquelle le champ électrique micro-onde est le plus fort, l'utilisation d'un aimant annulaire dont le rayon extérieur est bien supérieur au rayon de cette zone permet l'obtention d'une zone $Z_{RCE}$ sensiblement parallèle au plan de sortie P de l'applicateur.

Comme indiqué plus haut, on considère que cette zone de champ électrique fort s'étend sur un rayon de l'ordre du double du rayon R de l'applicateur.

Par conséquent, si l'aimant annulaire 22 présente un rayon extérieur supérieur à 2R (cf. figure 4), la zone $Z_{RCE}$, qui correspond à l'intersection de la zone de champ magnétique située près de la surface de champ magnétique d'intensité égale à $B_0$ et de la zone d'application des micro-ondes, est sensiblement parallèle au plan de sortie de l'applicateur sur toute son étendue de rayon 2R.

D'autre part, du fait de la présence de l'aimant annulaire 22 ayant un rayon extérieur supérieur à 2R, les lignes de champ qui partent du pôle situé au niveau du plan de sortie de l'applicateur restent sensiblement parallèles à l'axe X de l'applicateur pendant leur traversée de la zone $Z_{RCE}$ de rayon 2R, jusqu'à la périphérie de cette zone.

En d'autres termes, l'aimant annulaire a pour effet de « redresser » les lignes de champ dans la partie centrale de la zone $Z_{RCE}$ de rayon 2R.

A titre purement indicatif, le rayon R d'un applicateur micro-onde est généralement de l'ordre du cm, de sorte que si l'on choisit un aimant annulaire dont le rayon extérieur est de l'ordre de 2R à 3R, le diamètre de l'applicateur est de quelques cm.

On notera cependant que cette condition dimensionnelle s'appliquant à l'aimant permanent annulaire ne correspond qu'à un mode de réalisation particulier et il est possible, selon d'autres modes de réalisation décrits plus bas, d'obtenir des lignes de champ magnétique parallèles à l'axe X dans la zone $Z_{RCE}$ avec un aimant annulaire de plus faible rayon extérieur.

A titre de comparaison, la figure 5 illustre un applicateur non conforme à l'invention, c'est-à-dire dans lequel les lignes de champ magnétique L générées par la structure magnétique ne traversent pas la zone de couplage de résonance cyclotronique électronique selon une direction sensiblement parallèle à l'axe X de l'applicateur.

Dans cet exemple, un aimant permanent cylindrique 21 à aimantation axiale (schématisée par la flèche) est disposé dans l'âme centrale 11 à l'extrémité de l'applicateur micro-onde de rayon R.

La zone de couplage RCE en sortie d'applicateur est située à l'intersection de la zone de champ électrique fort (dont le rayon est égal à 2R) et de la zone dont le champ magnétique est voisin de $B_0$, c'est-à-dire, comme indiqué précédemment, entre $B_0$-15% et $B_0$+15%.

On peut observer clairement que les lignes L de champ magnétique, à l'exception de celles situées près du pôle (c'est-à-dire le centre de l'applicateur, qui est supposé de symétrie azimutale), ne traversent pas la zone de couplage RCE selon une direction sensiblement parallèle à l'axe X de l'applicateur micro-onde et se rebouclent immédiatement sur le pôle opposé de l'aimant.

Il en résulte en particulier que les électrons rapides dont les trajectoires s'enroulent sur ces lignes de champ magnétique (c'est-à-dire qui ne traversent pas la zone de couplage selon une direction sensiblement parallèle à l'axe de l'applicateur micro-onde) vont être collectés par l'applicateur au niveau du plan de sortie.

La puissance absorbée par ces électrons sera donc perdue dans le bombardement de la surface matérielle traversée par les lignes de champ et non dissipée dans la production de plasma.

Revenant maintenant à l'invention, on va décrire l'effet de l'applicateur sur les électrons et la génération du plasma.

En fonctionnement, l'applicateur débouche dans une enceinte contenant un gaz plasmagène.

Par exemple, l'applicateur est agencé de manière étanche à travers la paroi de ladite enceinte, le plan de sortie (extrémité de l'applicateur) étant affleurant avec la surface intérieure de ladite paroi.

Le gaz plasmagène peut être n'importe quel gaz dont les composants permettent de générer un plasma sous l'effet de l'onde électromagnétique micro-onde appliquée.

Dans les applications relatives à l'éclairage, le gaz plasmagène peut ainsi être constitué, de manière conventionnelle, d'un ou plusieurs gaz rares (notamment, de l'argon) et de mercure.

A titre d'exemples non limitatifs, des gaz comme l'azote, l'oxygène, les gaz halogénés, ou tout autre gaz présentant des propriétés physico-chimiques intéressantes en vue d'une application ciblée (traitement des effluents, traitements de surface), peuvent aussi être envisagés.

Les électrons présents, qui sont supposés être initialement de faible énergie, sont accélérés à la RCE dans la zone de couplage.

Ces électrons acquièrent donc une vitesse de rotation, et par conséquent une énergie de rotation grande devant l'énergie de translation initiale parallèle à la ligne de champ magnétique.

On peut donc considérer que le point miroir correspondant à une vitesse possédant une composante parallèle nulle se situe, pour chaque trajectoire électronique, sur la ligne de champ qui guide la trajectoire, à une valeur de champ magnétique légèrement plus élevée que dans la zone de couplage $Z_{RCE}$, c'est-à-dire plus près du pôle magnétique et du plan de sortie P de l'applicateur.

Si le sens de la vitesse parallèle initiale est orienté vers le plan de sortie P de l'applicateur, l'électron accéléré à la RCE dans la zone de couplage se dirige d'abord vers le point miroir M avant de s'y réfléchir et ensuite de s'en éloigner.

Si le sens de la vitesse parallèle initiale est orienté en direction opposée du plan de sortie P de l'applicateur, l'électron accéléré à la RCE continue à s'éloigner du plan de sortie de l'applicateur, sans se réfléchir sur le point miroir M.

Du fait que, comme indiqué précédemment, la zone de couplage RCE a été choisie suffisamment éloignée du plan de sortie de l'applicateur, tous les électrons rapides accélérés à la RCE finissent (sans réflexion ou après une réflexion sur le point miroir M) par s'éloigner du plan de sortie de l'applicateur et aucun des électrons rapides ne sera collecté par les différentes surfaces matérielles de l'applicateur.

Lorsque les électrons rapides s'éloignent du plan de sortie de l'applicateur, c'est-à-dire lorsqu'ils s'éloignent de la surface polaire des aimants permanents, l'intensité du champ magnétique diminue.

Dans leur mouvement hélicoïdal autour d'une ligne de champ, l'énergie cinétique de rotation des électrons rapides se transforme alors progressivement en énergie cinétique de translation parallèle aux lignes de champ, d'où l'apparition d'une accélération du mouvement le long des lignes de champ.

Naturellement, le long de leurs trajectoires, ces électrons rapides créent par collisions ionisantes du plasma, c'est-à-dire des électrons lents et des ions.

En raison de la charge d'espace créée par les électrons rapides, les ions sont à leur tour accélérés le long des lignes de champ magnétique vers les champs magnétiques d'intensité décroissante (en s'éloignant des points miroir M).

Il résulte de l'ensemble de ces mécanismes que le plasma est principalement produit au-delà des points miroirs M des électrons rapides définis précédemment et que la diffusion du plasma s'effectue préférentiellement dans le volume face au plan de sortie P de l'applicateur, et non vers l'applicateur.

Compte tenu des mécanismes de production et de diffusion du plasma, les pertes en électrons rapides et en plasma vers l'applicateur sont considérablement réduites, d'où une grande efficacité des applicateurs conformes à l'invention par rapport aux autres types d'applicateurs micro-onde.

Aux pressions plus élevées, où le champ magnétique n'est plus efficace, c'est-à-dire lorsque la pulsation micro-onde $\omega = 2\pi f_0$ est du même ordre que la fréquence de collisions $v$ des électrons ($v \approx \omega$), le couplage de la puissance micro-onde avec les électrons par exemple par absorption collisionnelle se substitue au couplage résonnant RCE.

Dans ce cas, le fait que la structure magnétique laisse libre le demi-espace au-delà du plan de sortie P de l'applicateur permet d'obtenir en sortie d'applicateur, au-delà d'une fenêtre diélectrique (permettant de séparer le volume à pression réduite au-delà du plan de sortie de l'applicateur de la pression atmosphérique), un disque de plasma.

Ladite fenêtre se présente sous la forme d'un anneau d'un matériau diélectrique agencé de manière étanche à l'intérieur du volume annulaire de propagation.

A basse pression (c'est-à-dire au-dessous d'une pression de l'ordre du Pa), l'allumage du plasma au sein de l'applicateur coaxial dans un espace de quelques mm entre l'âme centrale et le conducteur externe ne peut se produire (loi de Paschen), d'où la possibilité, dans ce cas, de positionner la fenêtre étanche en retrait (c'est-à-dire en amont sur le trajet des micro-ondes) du plan de sortie de l'applicateur.

Les applicateurs conformes à l'invention permettent donc, d'une part, de produire du plasma selon des conditions opératoires étendues (pression, fréquence, puissance), et, d'autre part, de réduire considérablement les pertes à basse pression dans des conditions de couplage RCE.

On va maintenant décrire, en référence aux figures 6 à 8, des modes de réalisation avantageux de l'invention.

La figure 6 présente un mode de réalisation permettant de réduire l'encombrement radial de l'applicateur, en réduisant le rayon extérieur de l'aimant annulaire par rapport au mode de réalisation illustré à la figure 4.

En effet, le « redressement » des lignes de champ à la périphérie de la zone $Z_{RCE}$ peut également être obtenu par l'utilisation de deux aimants annulaires concentriques dont celui situé à l'extérieur procure, au niveau du plan de sortie de l'applicateur, une intensité de champ magnétique supérieure à celle procurée par l'aimant situé à l'intérieur ; l'encombrement radial de l'aimant annulaire externe étant moindre que celui d'un aimant annulaire unique tel qu'utilisé dans le mode de réalisation de la figure 4.

Sur la figure 6, on a représenté l'aimant cylindrique 21 placé à l'extrémité de l'âme centrale 11, qui ne diffère pas de l'aimant décrit en référence à la figure 4, et deux aimants annulaires 22 et 23, l'aimant 23 entourant l'aimant 22.

Comme mentionné plus haut, les deux aimants annulaires peuvent être logés dans un logement annulaire (non illustré ici) de dimension adaptée prévu à l'extrémité du conducteur externe.

L'intensité de champ magnétique plus élevée de l'aimant extérieur 23 peut être obtenue, pour un matériau magnétique identique à celui de l'aimant intérieur 22, par une longueur selon l'axe X plus grande pour l'aimant extérieur 23 que pour l'aimant intérieur 22 (cas illustré à la figure 6).

De manière alternative (non illustrée), cette intensité magnétique peut être obtenue avec des aimants intérieur et extérieur de même longueur, mais avec un matériau magnétique présentant une aimantation plus élevée pour l'aimant extérieur.

L'utilisation de ces deux aimants annulaires permet ainsi de procurer un applicateur plus compact, son rayon total étant réduit.

La figure 7 présente un autre mode de réalisation permettant, dans le cadre d'un fonctionnement à basse pression à la RCE, de réduire l'encombrement radial de l'applicateur, en réduisant le rayon de la zone $Z_{RCE}$ de couplage par rapport au mode de réalisation illustré à la figure 4.

On peut en effet délimiter la zone de couplage $Z_{RCE}$ au moyen de surfaces matérielles.

Par exemple, comme illustré à la figure 7, on arrange un épaulement annulaire 14 recouvrant partiellement l'aimant annulaire 22 et présentant une hauteur (dans la direction X) au moins égale à la distance entre la zone $Z_{RCE}$ et le plan de sortie P de l'applicateur.

Ledit épaulement peut par exemple être constitué par une portion du conducteur externe 12.

La zone de couplage $Z_{RCE}$ dans laquelle les lignes de champ magnétique doivent être parallèles à l'axe X est donc plus restreinte dans la direction radiale, et, même si l'aimant annulaire présente un encombrement moins important, les lignes de champ situées à la périphérie de la zone $Z_{RCE}$ restent parallèles à l'axe X.

A haute pression, il est en revanche préférable de laisser libre l'espace à l'avant de l'applicateur ; on évitera donc un tel épaulement.

La figure 8 illustre un mode de réalisation permettant le refroidissement de l'applicateur, qui peut être nécessaire lorsque l'on met en oeuvre une forte puissance micro-onde.

Ainsi, on peut faire circuler un fluide diélectrique à l'intérieur du volume annulaire 13 de propagation des micro-ondes, en ayant au préalable obturé ce volume de manière étanche du côté du plan de sortie de l'applicateur, par exemple par une fenêtre 15 en un matériau diélectrique.

De manière alternative (non illustré), il est possible de refroidir l'âme centrale et/ou du conducteur externe par la circulation d'un fluide adéquat (par exemple, de l'eau) à l'intérieur de l'âme centrale et/ou du conducteur externe.

La définition et la réalisation des canaux permettant cette circulation est connue en elle-même et à la portée de l'homme du métier selon les contraintes techniques rencontrées.

Naturellement, ces différents modes de réalisation peuvent éventuellement combinés par l'homme du métier en fonction des contraintes techniques rencontrées, notamment en termes de puissance, d'encombrement requis, etc.

Parmi les applications des applicateurs conformes à l'invention, on peut citer l'éclairage, les sources plasma étendues pour traitements de surface, les applications à la gravure (microélectronique et nanotechnologies), le traitement des effluents gazeux, la stérilisation plasma, les sources d'ions, la propulsion ionique (liste non limitative).

Selon les applications, les applicateurs tels que décrits ci-dessus peuvent être employés de manière unitaire.

Tel est le cas par exemple dans l'éclairage, où un applicateur est inséré dans une ampoule contenant un gaz plasmagène permettant d'émettre des UV ou du rayonnement visible.

Un autre exemple est l'utilisation de l'applicateur en tant que source d'ions ponctuelle.

D'autres applications, telles que le traitement de grandes surfaces, la formation de sources d'ions étendues, la réalisation de volumes de plasma uniformes, peuvent en revanche nécessiter une pluralité d'applicateurs pour former une source de plasma étendue.

Dans ce cas, les applicateurs peuvent être agencés selon des réseaux à une dimension (c'est-à-dire alignés pour former une source linéaire), à deux dimensions (l'ensemble des plans de sortie étant répartis sur une même surface pour former une source plane) ou à trois dimensions (les plans de sortie des différents applicateurs appartiennent à des plans différents entourant un volume de plasma).

La disposition des applicateurs les uns par rapport aux autres et la distance entre applicateurs est définie par l'homme du métier en fonction de l'application visée.

Par ailleurs, selon les cas, deux applicateurs adjacents peuvent présenter des aimantations de même sens (par exemple, dans le cas d'une source d'ions étendue) ou bien alternées (dans certains cas de confinement du plasma en volume).

Dans les cas de distributions d'applicateurs suivant un réseau unidimensionnel (ligne), bidimensionnel (surface plane) ou tridimensionnel (surface enfermant un volume) pour réaliser des lignes, des surfaces ou de grands volumes de plasma, le cas des distributions d'applicateurs avec des champs magnétiques alternés d'un applicateur vis-à-vis de son ou de ses voisins ne pose pas de réel problème au niveau de la fermeture du champ magnétique aux limites du réseau.

Par contre, dans le cas des distributions d'applicateurs présentant des applicateurs avec des aimantations axiales toutes de même sens, la fermeture du champ magnétique en périphérie du réseau peut être obtenue, en fonction de l'application, selon l'un des modes de réalisation décrits ci-dessous.

Selon une première option, on fait en sorte que la structure magnétique 100a présentant une aimantation axiale de même sens que celle de l'aimant central unique de chaque applicateur 1 puisse remplir tout l'espace entre applicateurs, comme illustré sur les figures 9A-9B.

Ce mode de réalisation peut être appliqué très favorablement aux sources d'ions et en particulier aux propulseurs ioniques.

Selon une seconde option, éventuellement combinée à la première, une structure magnétique linéaire 100b d'aimantation axiale mais de sens opposé à celle de l'aimant central unique de chaque applicateur 1 est disposée à la périphérie du réseau d'applicateurs 1 en se refermant sur elle-même (cf. figures 9A-9B) de manière à former à la périphérie du réseau d'applicateurs une structure magnétique dite de type "magnétron" où les électrons ainsi piégés dans la structure magnétron périphérique 100a, 100b dérivent (dérive magnétique) le long de la structure magnétique et ne sont donc pas perdus sur les parois.

Une troisième option applicable à l'un et/ou l'autre des deux modes de réalisation présentés ci-dessus consiste, dans le cadre d'un dispositif de pulvérisation magnétron assistée par plasma micro-onde, à entourer des applicateurs par une structure magnétron de pulvérisation (ou inversement entourer une structure magnétron de pulvérisation par des applicateurs) de manière à combiner pulvérisation magnétron et assistance ionique à partir du plasma créé par des applicateurs micro-onde.

Un tel dispositif est illustré sur les figures 10A-10B où une ligne de trois applicateurs 1 de même sens d'aimantation est entourée par une structure magnétron de pulvérisation 100.

Dans ce cas, la structure magnétron 100 peut être polarisée négativement (en continu (DC), radiofréquence (RF) ou en régime pulsé) par rapport à la terre à laquelle les applicateurs micro-onde 1 sont généralement reliés.

Une cible 101 est disposée au-dessus de la structure magnétron de pulvérisation 100.

En outre, si une interaction modérée est souhaitée entre le plasma produit par les applicateurs 1 et celui produit par la structure magnétron 100, il est préférable de mettre en oeuvre une structure magnétron avec les sens d'aimantation 100a, 100b indiqués sur la figure 10B, c'est-à-dire avec la structure 100a présentant le même sens d'aimantation que les applicateurs 1 directement adjacente auxdits applicateurs, la structure 100b de sens opposé entourant la structure 100a.

Au contraire, si une très forte interaction est souhaitée, il faut inverser les sens d'aimantation des aimants 100a, 100b de la structure magnétron 100 de façon à mettre en commun les électrons issus des plasmas produits par la structure magnétron 100 et par les applicateurs micro-onde 1.

Suivant l'application, des configurations différentes ou plus complexes que celles indiquées sur les figures 9A-9B et 10A-10B peuvent être mises en oeuvre, mais les mêmes principes que ceux décrits ci-dessus peuvent leur être appliqués tout en restant dans le cadre de l'invention.

Parmi les avantages procurés par l'invention, on notera en premier lieu l'efficacité énergétique du plasma produit, en raison à la fois de la réduction des pertes en électrons rapides sur les surfaces de l'applicateur et de la réduction des pertes par diffusion du plasma produit vers les surfaces de l'applicateur.

Un avantage qui résulte directement du précédent est la réduction de la contamination issue des surfaces de l'applicateur.

Un autre avantage est la réduction de la puissance déposée sur les surfaces de l'applicateur par les espèces chargées du plasma (électrons rapides, électrons thermiques, ions), d'où un besoin moindre du refroidissement de l'applicateur.

En raison de la production et de l'injection du plasma en avant de l'applicateur, le dispositif est extrêmement intéressant soit pour améliorer l'extraction des ions dans les sources d'ions (pré-accélération des ions), soit pour produire des faisceaux d'ions neutralisés dans les applications à la propulsion ionique.

Enfin, le fait d'avoir une déplétion de plasma entre l'applicateur et le plan de sortie de l'applicateur favorise, à basse pression, la propagation des micro-ondes jusqu'à la zone de couplage RCE, d'où une réduction de la puissance réfléchie et une amélioration corrélative du rendement énergétique.

**REFERENCES**

FR 2 797 372
FR 2 838 020
FR 2 904 177
FR 2 904 178
FR 2 938 150
FR 2 840 451
M. Moisan et J. Pelletier, Physique des plasmas collisionnels - Application aux décharges haute fréquence, EDP Sciences, Collection Grenoble Sciences, Les Ulis, France (2006), page 215

**Revendications**

1.  Applicateur micro-onde coaxial (1) pour la production de plasma, comprenant un tube coaxial électriquement conducteur formé d'une âme centrale (11) et d'un conducteur externe (12) entourant l'âme centrale (11) et séparé de celle-ci par un volume annulaire (13) de propagation des micro-ondes, ledit applicateur comprenant:

    - un aimant permanent cylindrique (21) dont la direction d'aimantation est parallèle à l'axe (X) de l'applicateur (1), agencé à l'extrémité de l'âme centrale (11) et,
    - au moins un aimant permanent annulaire (22) dont la direction d'aimantation est parallèle à l'axe (X) de l'applicateur (1) et de même sens que l'aimantation de l'aimant cylindrique central (21), agencé à l'extrémité du conducteur externe (12), l'aimantation desdits aimants (21, 22) étant choisie de sorte à former un champ magnétique propre à procurer, dans une zone ($Z_{RCE}$) distante de l'extrémité de l'applicateur, un couplage de résonance cyclotronique électronique avec le champ électrique micro-onde généré par ledit applicateur (1) ledit applicateur étant **caractérisé en ce qu'**il comprend ultérieurement:
    tous les aimants (21,22) agencés à l'extrémité du tube coaxial (11,12) présentant le même sens d'aimantation, le rayon extérieur et l'aimantation de l'aimant annulaire (22) étant en outre choisis de sorte que les lignes (L) de champ magnétique générées par lesdits aimants (21, 22) traversent la zone de couplage de résonance cyclotronique électronique ($Z_{RCE}$) selon une direction sensiblement parallèle à l'axe (X) de l'applicateur (1).

2. Applicateur selon la revendication 1, **caractérisé en ce que** le rayon extérieur de l'aimant annulaire (22) est au moins le double du rayon extérieur (R) du volume annulaire (13) de propagation des micro-ondes.

3. Applicateur selon la revendication 1, **caractérisé en ce qu'**il comprend, autour de l'aimant annulaire (22), dit premier aimant annulaire, un second aimant permanent annulaire (23), à aimantation axiale de même sens que l'aimantation de l'aimant cylindrique central (21), ledit second aimant annulaire (23) présentant une intensité de champ magnétique supérieure à celle du premier aimant annulaire (22).

4. Applicateur selon la revendication 1, **caractérisé en ce qu'**il comprend un épaulement (14) recouvrant une région externe de l'extrémité de l'aimant annulaire (22), de sorte à limiter radialement la surface de la zone de couplage de résonance cyclotronique électronique ($Z_{RCE}$).

5. Applicateur selon l'une des revendications 1 à 4, **caractérisé en ce que** l'âme centrale (11) et/ou le conducteur externe (12) du tube coaxial comprend un circuit de circulation d'un fluide de refroidissement.

6. Applicateur selon l'une des revendications 1 à 5, **caractérisé en ce que** le volume annulaire de propagation des micro-ondes est obturé à l'extrémité de l'applicateur ou en amont de ladite extrémité par une fenêtre en un matériau diélectrique.

7. Dispositif de production de plasma, comprenant une enceinte contenant un gaz plasmagène et au moins un applicateur (1) selon l'une des revendications 1 à 6 dont l'extrémité portant les aimants permanents cylindrique et annulaire (21, 22) débouche dans ladite enceinte.

8. Dispositif selon la revendication 7, **caractérisé en ce qu'**il comprend une pluralité d'applicateurs (1) répartis dans l'enceinte de sorte à former un réseau unidimensionnel, bidimensionnel ou tridimensionnel.

9. Dispositif selon la revendication 8, **caractérisé en ce que** les aimants permanents de l'ensemble des applicateurs présentent le même sens d'aimantation.

10. Dispositif selon la revendication 9, **caractérisé en ce que** le réseau d'applicateurs est entouré par une structure magnétique (100b) présentant une direction d'aimantation parallèle à celui des applicateurs mais de sens opposé.

11. Dispositif selon la revendication 9, **caractérisé en ce que** le réseau d'applicateurs est entouré par une structure magnétron de pulvérisation (100).

12. Dispositif selon la revendication 8, **caractérisé en ce que** les aimants permanents de l'ensemble des applicateurs présentent des aimantations alternées.

13. Procédé de production de plasma par micro-onde dans une enceinte contenant un gaz plasmagène, comprenant la propagation de micro-ondes dans un applicateur micro-onde coaxial selon l'une des revendications 1 à 6 débouchant dans ladite enceinte et l'application, à l'extrémité dudit applicateur, d'un champ magnétique propre à procurer un couplage cyclotronique électronique avec le champ électrique micro-onde dans une zone ($Z_{RCE}$) distante de l'extrémité de l'applicateur, les lignes (L) dudit champ magnétique traversant la zone de couplage de résonance cyclotronique électronique ($Z_{RCE}$) selon une direction sensiblement parallèle à l'axe (X) de l'applicateur (1).

14. Procédé selon la revendication 13, **caractérisé en ce que** la pression absolue dans l'enceinte est comprise entre $10^{-2}$ Pa et $10^3$ Pa.

15. Procédé selon l'une des revendications 13 à 14, **caractérisé en ce que** l'on produit le plasma au moyen d'une pluralité d'applicateurs répartis dans l'enceinte de sorte à former un réseau unidimensionnel, bidimensionnel ou tridimensionnel.

**Patentansprüche**

1. Koaxialer Mikrowellenapplikator (1) für die Erzeugung von Plasma, umfassend eine elektrisch leitende koaxiale Röhre, die aus einem zentralen Kern (11) und einem äußeren Leiter (12) gebildet ist, der den zentralen Kern (11) umgibt und von demselben durch ein ringförmiges Volumen (13) zur Ausbreitung der Mikrowellen getrennt ist, wobei der Applikator umfasst:

- einen am Ende des zentralen Kerns (11) eingerichteten zylinderförmigen Dauermagneten (21), dessen Magnetisierungsrichtung zur Achse (X) des Applikators (1) parallel ist, und
- mindestens einen am Ende des äußeren Leiters (12) eingerichteten ringförmigen Dauermagneten (22), dessen Magnetisierungsrichtung zur Achse (X) des Applikators (1) parallel und von gleicher Orientierung ist wie die Magnetisierung des zentralen zylinderförmigen Magneten (21),

wobei die Magnetisierung der Magneten (21, 22) so ausgewählt ist, dass ein Magnetfeld gebildet wird, das dazu in der Lage ist, in einem vom Ende des Applikators entfernt liegenden Bereich ($Z_{RCE}$) eine elektronische zyklotronische Resonanzkopplung mit dem vom Applikator (1) generierten elektrischen Mikrowellenfeld bereitzustellen,
wobei der Applikator **dadurch gekennzeichnet ist, dass** er weiterhin umfasst: alle die am Ende der koaxialen Röhre (11, 12) eingerichteten Magneten (21, 22) dieselbe Magnetisierungsorientierung aufweisen,
wobei der Außenradius und die Magnetisierung des ringförmigen Magneten (22) weiter so gewählt sind, dass die Magnetfeldlinien (L), die von den Magneten (21, 22) generiert werden, in eine Richtung durch den elektronischen zyklotronischen Resonanzkopplungsbereich ($Z_{RCE}$) verlaufen, die im Wesentlichen zur Achse (X) des Applikators (1) parallel ist.

2. Applikator nach Anspruch 1, **dadurch gekennzeichnet, dass** der Außenradius des ringförmigen Magneten (22) mindestens das Doppelte des Außenradius (R) des ringförmigen Volumens (13) zur Ausbreitung der Mikrowellen beträgt.

3. Applikator nach Anspruch 1, **dadurch gekennzeichnet, dass** er um den ringförmigen Magneten (22) herum, der als erster ringförmiger Magnet bezeichnet wird, einen zweiten ringförmigen Dauermagneten (23) umfasst, mit axialer Magnetisierung von gleicher Orientierung wie die Magnetisierung des zentralen zylinderförmigen Magneten (21), wobei der zweite ringförmige Magnet (23) eine Magnetfeldstärke aufweist, die größer ist als diejenige des ersten ringförmigen Magneten (22).

4. Applikator nach Anspruch 1, **dadurch gekennzeichnet, dass** er ein Schulterstück (14) umfasst, das eine äußere Region des Endes des ringförmigen Magneten (22) so bedeckt, dass die Fläche des elektronischen zyklotronischen Resonanzkopplungsbereichs ($Z_{RCE}$) radial begrenzt wird.

5. Applikator nach einem der Ansprüche 1 bis 4, **dadurch gekennzeichnet, dass** der zentrale Kern (11) und/oder der äußere Leiter (12) der koaxialen Röhre einen Kreis zum Umwälzen eines Kühlfluids umfasst.

6. Applikator nach einem der Ansprüche 1 bis 5, **dadurch gekennzeichnet, dass** das ringförmige Volumen zur Ausbreitung der Mikrowellen am Ende des Applikators oder stromaufwärts des Endes durch ein Fenster aus einem dielektrischen Material verschlossen ist.

7. Plasmaerzeugungsvorrichtung, die einen Behälter, der ein plasmagenes Gas enthält, und mindestens einen Applikator (1) nach einem der Ansprüche 1 bis 6 umfasst, dessen Ende, das den zylinderförmigen und den ringförmigen Dauermagneten (21, 22) trägt, im Behälter mündet.

8. Vorrichtung nach Anspruch 7, **dadurch gekennzeichnet, dass** sie eine Vielzahl von Applikatoren (1) umfasst, die so im Behälter verteilt sind, dass ein eindimensionales, zweidimensionales oder dreidimensionales Netz gebildet wird.

9. Vorrichtung nach Anspruch 8, **dadurch gekennzeichnet, dass** die Dauermagneten der Gesamtheit der Applikatoren dieselbe Magnetisierungsorientierung aufweisen.

10. Vorrichtung nach Anspruch 9, **dadurch gekennzeichnet, dass** das Applikatorennetz von einer magnetischen Struktur (100b) umgeben ist, die eine Magnetisierungsrichtung aufweist, welche zu derjenigen der Applikatoren parallel, aber von entgegengesetzter Orientierung ist.

11. Vorrichtung nach Anspruch 9, **dadurch gekennzeichnet, dass** das Applikatorennetz von einer Magnetronzerstäubungsstruktur (100) umgeben ist.

12. Vorrichtung nach Anspruch 8, **dadurch gekennzeichnet, dass** die Dauermagneten der Gesamtheit der Applikatoren alternierende Magnetisierungen aufweisen.

13. Verfahren zur Erzeugung von Plasma durch Mikrowellen in einem Behälter, der ein plasmagenes Gas enthält, umfassend die Ausbreitung von Mikrowellen in einem koaxialen Mikrowellenapplikator nach einem der Ansprüche 1 bis 6, der in dem Behälter mündet, und das Anlegen, am Ende des Applikators, eines Magnetfeldes, das dazu in der Lage ist, in einem vom Ende des Applikators entfernt liegenden Bereich ($Z_{RCE}$) eine elektronische zyklotronische Kopplung mit dem elektrischen Mikrowellenfeld bereitzustellen, wobei die Linien (L) des Magnetfeldes in eine Richtung durch den elektronischen zyklotronischen Resonanzkopplungsbereich ($Z_{RCE}$) verlaufen, die im Wesentlichen zur Achse (X) des Applikators (1) parallel ist.

14. Verfahren nach Anspruch 13, **dadurch gekennzeichnet, dass** der absolute Druck im Behälter im Bereich zwischen $10^{-2}$ Pa und $10^3$ Pa liegt.

15. Verfahren nach einem der Ansprüche 13 bis 14, **dadurch gekennzeichnet, dass** das Plasma mittels einer Vielzahl von Applikatoren erzeugt wird, die so im Behälter verteilt sind, dass ein eindimensionales, zweidimensionales oder dreidimensionales Netz gebildet wird.

## Claims

1. Coaxial microwave applicator (1) for producing plasma, comprising an electrically conductive coaxial tube formed of a central core (11) and an external conductor (12) surrounding the central core (11) and separated from it by an annular volume (13) for propagating microwaves, said applicator comprising:

   - a cylindrical permanent magnet (21) of which the magnetisation direction is parallel to the axis (X) of the applicator (1), arranged at the end of the central core (11) and,
   - at least one annular permanent magnet (22) of which the magnetisation direction is parallel to the axis (X) of the applicator (1) and of the same orientation as the magnetisation of the central cylindrical magnet (21), arranged at the end of the external conductor (12),

   the magnetisation of said magnets (21, 22) being selected so as to form a magnetic field, suitable to provide, in a zone ($Z_{ECR}$) distant from the end of the applicator, an electronic cyclotronic resonance coupling with the microwave electrical field generated by said applicator (1), said applicator being **characterised in that** it later comprises all the magnets (21, 22) arranged at the end of the coaxial tube (11, 12) having the same magnetisation orientation, the outer radius and the magnetisation of the annular magnet (22) furthermore being selected such that the lines (L) of magnetic field generated by said magnets (21, 22) pass through the electronic cyclotronic resonance coupling zone ($Z_{ECR}$), along a direction substantially parallel to the axis (X) of the applicator (1).

2. Applicator according to claim 1, **characterised in that** the outer radius of the annular magnet (22) is at least double the outer radius (R) of the annular volume (13) for propagating microwaves.

3. Applicator according to claim 1, **characterised in that** it comprises, around the annular magnet (22), called first annular magnet, a second annular permanent magnet (23), with axial magnetisation in the same orientation as the magnetisation of the central cylindrical magnet (21), said second annular magnet (23) having a magnetic field intensity greater than that of the first annular magnet (22).

4. Applicator according to claim 1, **characterised in that** it comprises a shoulder (14) covering an outer region of the end of the annular magnet (22), so as to radially limit the surface area of the electronic cyclotronic resonance coupling zone ($Z_{ECR}$).

5. Applicator according to one of claims 1 to 4, **characterised in that** the central core (11) and/or the external conductor (12) of the coaxial tube comprises a circuit for circulating a cooling fluid.

6. Applicator according to one of claims 1 to 5, **characterised in that** the annular volume for propagating microwaves is blocked at the end of the applicator or upstream of said end by a window made of a dielectric material.

7. Plasma production device, comprising an enclosure containing a plasmagen gas and at least one applicator (1) according to one of claims 1 to 6, of which the end carrying the cylindrical and annular permanent magnets (21, 22) opens into said enclosure.

8. Device according to claim 7, **characterised in that** it comprises a plurality of applicators (1), distributed in the enclosure, so as to form a one-dimensional, two-dimensional or three-dimensional network.

9. Device according to claim 8, **characterised in that** the permanent magnets of all of the applicators have the same orientation of magnetisation.

10. Device according to claim 9, **characterised in that** the applicator network is surrounded by a magnetic structure (100b) having a magnetisation direction parallel to that of the applicators, but in the opposite orientation.

11. Device according to claim 9, **characterised in that** the applicator network is surrounded by a sputtering magnetron structure (100).

12. Device according to claim 8, **characterised in that** the permanent magnets of all of the applicators have alternating magnetisations.

13. Method for producing plasma by microwaves in an enclosure containing a plasmagen gas, comprising the propagation of microwaves in a coaxial microwave applicator according to one of claims 1 to 6 opening into said enclosure and application, at the end of said applicator, of a magnetic field suitable to providing an electronic cyclotronic coupling with the electrical microwave field in a zone ($Z_{ECR}$) distant from the end of the applicator, the lines (L) of said magnetic field passing through the electronic cyclotronic resonance coupling zone ($Z_{ECR}$) along a direction substantially parallel to the axis (X) of the applicator (1).

14. Method according to claim 13, **characterised in that** the absolute pressure in the enclosure is between $10^{-2}$ Pa and $10^3$ Pa.

15. Method according to one of claims 13 to 14, **char-**

**acterised in that** plasma is produced by means of a plurality of applicators, distributed in the enclosure so as to form a one-directional, two-directional or three-dimensional network.

## FIG. 1

## FIG. 2

FIG. 3

## FIG. 4

## FIG. 5

## FIG. 6

## FIG. 7

FIG. 8

# FIG. 9A

# FIG. 9B

## FIG. 10A

## FIG. 10B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2797372
- FR 2838020
- FR 2904177
- FR 2904178
- FR 2938150
- FR 2840451
- FR 2840451 M

**Littérature non-brevet citée dans la description**

- Physique des plasmas collisionnels - Application aux décharges haute fréquence. **M. MOISAN ; J. PELLETIER.** Collection Grenoble Sciences. EDP Sciences, 2006, 215